# EUROPÄISCHE PATENTSCHRIFT

(11) **EP 0 752 171 B1**
(45) Veröffentlichungstag und Bekanntmachung des Hinweises auf die Patenterteilung: **10.12.1997**
(21) Anmeldenummer: 95910450.6
(22) Anmeldetag: 08.03.1995
(51) Int. Cl.: H03B 5/18, H01P 7/10

(54) **HOCHFREQUENZOSZILLATOR IN PLANARBAUWEISE**
PLANAR-CONSTRUCTION HIGH-FREQUENCY OSCILLATOR
OSCILLATEUR HAUTE FREQUENCE DE STRUCTURE PLANAR

(30) Priorität: 23.03.1994 DE 4410025
(43) Veröffentlichungstag der Anmeldung: 08.01.1997
(73) Patentinhaber: SIEMENS AKTIENGESELLSCHAFT, 80333 München (DE)
(72) Erfinder: HEIDE, Patric, D-81371 München (DE)
(86) Internationale Anmeldenummer: DE9500325
(87) Internationale Veröffentlichungsnummer: WO9526073

(56) Entgegenhaltungen:
- EP-A- 0 399 770
- GB-A- 2 239 988
- US-A- 4 731 611
- US-A- 4 871 983
- US-A- 4 982 167

## Beschreibung

Die Erfindung betrifft einen mit einem dielektrischen Resonator stabilisierten Hochfrequenzoszillator in Planarbauweise. Ein derartiger Oszillator, auch als dielectric resonator oscillator (DRO) bezeichnet, wird in einem Radarsensor für den Mikrowellen- / Millimeterwellen- Bereich verwendet. Der Oszillator weist ein aktives Element, einen sogenannten HF-Verstarker auf, welcher durch ein Rückkopplungsnetzwerk gezielt instabilisiert und damit zu Schwingungen angeregt wird. Als Rückkopplungsnetzwerk dient ein schmalbandiges Transmissions- oder Reflexionsfilter mit möglichst hoher Güte, welches unter Verwendung eines dielektrischen Resonators stabilisiert wird. Ein Transmissionsfilter ist ein Filter, das das Signal bei der Resonanzfrequenz zum Ausgang hin passieren läßt. Ein Reflexionsfilter ist ein Filter, bei dem das eingespeiste Signal nur bei der Resonanzfrequenz reflektiert wird.

Ein dielectric resonator oscillator ist in Bahl, I., Bhartia, P.: "Microwave Solid State Circuit Design", Chapter 9, John Wiley & Sons, 1988 beschrieben. Ebenso sind dort einige DRO-Grundschaltungen angegeben. Die Schwingfrequenz des Oszillators wird mittels des dielektrischen Resonators festgelegt. Dieser wirkt als schmalbandiges Frequenzfilter der Güte Q.

Nachteilig an den bekannten Oszillatoren ist, daß der dielektrische Resonator bei seiner Grundresonanzfrequenz (TE_{01δ}-Mode) betrieben wird. Die übliche Ankopplung des Resonators an die Schaltung ergibt insbesondere bei Oszillatoren für sehr hohe Frequenzen ( ≥ 15 ... 20 GHz) eine geringe Güte des Rückkopplungsfilters. Demzufolge verschlechtert sich die Temperaturstabilität und die Lastabhängigkeit des DROs.

Das Betragsmaximum der Filterkurve sinkt etwa exponentiell mit dem steigendem Abstand zwischen dem dielektrischen Resonator und der HF-Leitung, gleichzeitig steigt dabei aber die Güte Q des Filters. Da für die Realisierung temperaturstabiler DROs mit geringem Phasenrauschen eine möglichst hohe Güte Q erforderlich ist, könnte der dielektrische Resonator möglichst schwach angekoppelt werden. Zur Aufrechterhaltung der Oszillatorschwingung muß diese schwächere Verkopplung von dielektrischem Resonator und aktivem Element durch eine Erhöhung der Verstärkung des aktiven Elements ausgeglichen werden. Dem sind allerdings durch die maximal vom aktiven Element lieferbare Verstärkung enge Grenzen gesetzt.

In der GB 2 239 988 A ist ein dielektrischer Resonator beschrieben, der als flacher Zylinder ausgebildet und auf der Oberseite eines Substrates benachbart zu einer Streifenleitung angebracht ist. Der Resonator ist mit seiner Mantelfläche auf der Oberseite des Substrates befestigt und ggf. schräg zu dem Streifenleiter ausgerichtet. Der Resonator wird im Grundmode TE_{01δ} betrieben.

In der US 4,982,167 ist ein Oszillator mit einem an eine Streifenleitung angekoppelten dielektrischen Resonator beschrieben. An einem Ende der Streifenleitung befindet sich der für den Betrieb des Oszillators vorgesehene Transistor. Am anderen Ende ist die Streifenleitung durch einen für elektrostatische Kopplung hinreichend schmalen Spalt unterbrochen, und das auf diese Weise abgetrennte Ende der Streifenleitung ist mit einem Widerstand abgeschlossen.

In der US 4,871,983 ist ein Oszillator beschrieben, bei dem ein dielektrischer Resonator an eine Streifenleitung mit zwei Anteilen und an eine weitere Streifenleitung, die in einer anderen Ebene angeordnet und für Feinabstimmung vorgesehen ist, angekoppelt ist. In der EP 0 399 770 A1 ist eine Anordnung mit einem dielektrischen Resonator beschrieben, bei dem der Resonator als flacher Zylinder auf einem Sockel angeordnet ist. Der Resonator und der Sockel können in der Mitte eine Bohrung aufweisen, die zur Befestigung des Resonators auf einer Substratoberseite dient. In der US 4,731,611 ist ein Oszillator mit einem an eine Streifenleitung angekoppelten dielektrischen Resonator für Betrieb als Doppler-Radar beschrieben. Als Oszillator sind ein GuNN-Element, eine IMPATT-Diode, eine BARITT-Diode oder ein Feldeffekttransistor angegeben.

Aufgabe der Erfindung ist es, einen Oszillator mit deutlich verbesserten Eigenschaften hinsichtlich des Oszillatorrauschens und der Temperaturstabilität anzugeben.

Die Aufgabe wird durch einen Oszillator mit den Merkmalen des Anspruchs 1 gelöst. Weitere Ausgestaltungen ergeben sich aus den abhängigen Ansprüchen.

Bei dem erfindungsgemäßen Oszillator ergibt sich eine hohe Temperaturstabilität sowie eine weitgehende Lastunabhangigkeit des Oszillators und eine Verringerung der dielektrischen und der ohmschen Verluste. Auch die Wirbelstromverluste lassen sich wirksam verringern.

Vorteilhafter Weise ist der Durchmesser des dielektrischen Resonators größer als der Abstand der planaren Leiterbahnen vorzusehen, weil damit eine bessere Ankopplung erfolgen kann.

Die planaren Leiterbahnen koplanar auszuführen, hat den Vorteil, daß das je nach Oszillatorschaltung notwendige Durchkontaktieren vermieden werden kann.

Die planaren Leiterbahnen als Mikrostreifenleitungen auszuführen, hat den Vorteil, daß hierfür ausgereifte Simulationsprogramme zur Berechnung der Schaltung verfügbar sind, was die Entwicklung vereinfacht.

Je nach Anwendungsfall ist es vorteilhafter den Verstärker als Transistor, als Impatt-Diode oder als Gunnelement vorzusehen.

Anhand der Figuren soll die Erfindung näher erläutert werden.
- Figur 1: zeigt das Prinzip eines reflection type dielectric resonator oscillator.
- Figur 2: zeigt das Prinzip eines transmission type DROs.
- Figur 3: zeigt eine konventionelle Ankopplung bei der der dielektrischen Resonator mit seiner Stirnfläche auf dem Substrat liegt und die neue Ankopplung bei der der dielektrischen Resonator auf seiner Mantelfläche steht.
- Figur 4: zeigt einen Vergleich der Bandbreiten (und der Guten Q) für ein Reflexionsfilter bei einer herkömmlichen Ankopplung und der neuen Ankopplung.
- Figur 5: zeigt beispielhaft den Aufbau eines verbesserten HF-Oszillators mit neuartiger Ankopplung des dielektrischen Resonators mit hoher Güte Q (transmission type DRO).
- Figur 6: zeigt das Frequenzspektrum des verbesserten HF-Oszillators aus Fig. 5 für 24GHz.
- Figur 7: zeigt typische Filterkurven eines Reflexionsfilters mit einem kreisrunden und einem abgeplatteten dielektrischen Resonator.
- Figur 8: zeigt beispielhaft den Aufbau eines verbesserten HF-Oszillators mit neuartiger Ankopplung des dielektrischen Resonators mit hoher Güte Q, wobei die Ankopplung in erster Linie mit dem Verstarker erfolgt (reflection type DRO).

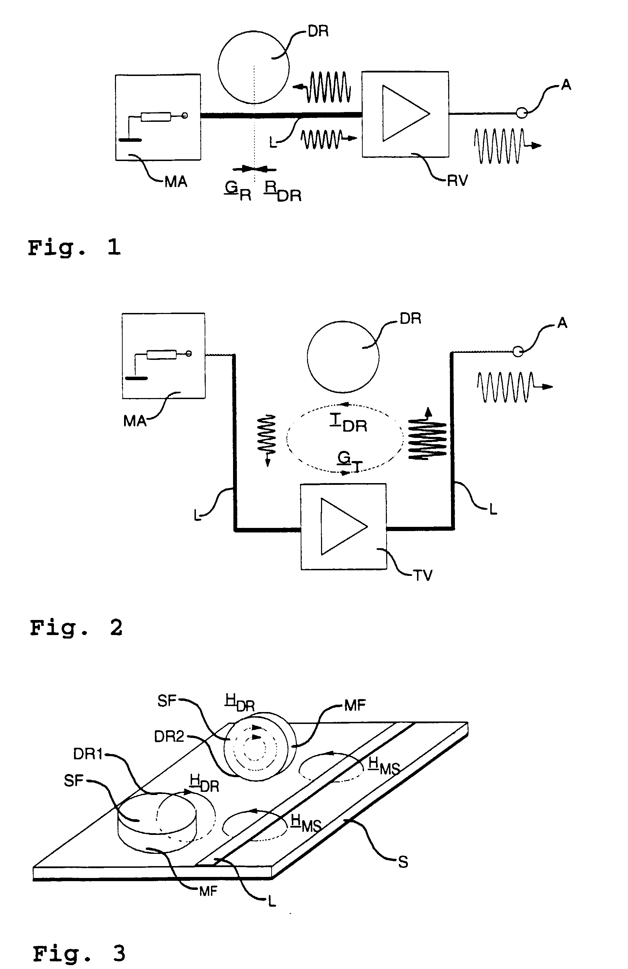

Ein DRO besteht aus einer geschlossenen Schleife, in welcher ein aktives Element, ein Verstärker (z.B. ein Bipolartransistor, ein Feldeffekttransistor, eine Gunn-Diode oder eine Impatt-Diode) und ein dielektrischer Resonator angeordnet sind. Je nach Verwendung des aktiven Elements als Reflexionsverstarker RV oder als Transmissionsverstärker TV werden die Oszillatoren als reflexion-type DRO, vergleiche Figur 1, oder als transmisson-type DRO, vergleiche Figur 2, bezeichnet. Entsprechend wirkt der Resonator DR als Reflexions- oder als Transmissionsfilter.

Der Reflexionsverstarker RV in Figur 1 besitzt eine komplexe Reflexionsverstarkung V_{R} mit |V_{R}| > 1. Die Rückkopplung wird durch einen dielektrischen Resonator DR ermöglicht. Schwingungen treten auf, wenn die Bedingung V_{R} · R_{DR} ≥ 1 erfüllt ist. R_{DR} ist der komplexe Reflexionsfaktor des dielektrischen Resonators DR. Der Reflexionsverstarker RV ist über eine planare Hochfrequenzleitung L, meist in Form einer Mikrostreifenleitung, aber auch als koplanare Leitung denkbar, mit einem Mikrowellenabsorber MA verbunden. Zwischen dem Mikrowellenabsorber MA und dem Reflexionsverstarker RV ist der dielektrische Resonator DR angeordnet, der über sein Sreufeld mit dem Feld der Hochfrequenzleitung L koppelt. An beliebiger Stelle der Oszillatorschaltung kann ein Ausgangssignal der Schwingfrequenz fₛ abgegriffen werden. Die Temperaturstabilität und das Phasenrauschen werden entscheidend von der Güte Q der Rückkopplungsschleife, also dem dielektrischen Resonator DR bestimmt. Der dielektrische Resonator DR wirkt in einem reflektion-type DRO als Reflexionsfilter.

Bei dem in Figur 2 dargestellten transmission-typ DRO besitzt der Transmissionsverstärker TV einen komplexen Transmissionsverstärkungsfaktor V_{T} mit |V_{T}| > 1. Ein Modenspringen, wie bei dem in Figur 1 dargestellten Oszillator, kann hier nicht auftreten, weil die parallele Rückkopplung nur bei der Resonanzfrequenz wirksam ist. In diesem Fall lautet die Schwingbedingung V_{T} · T_{DR} = 1. T_{DR} ist der komplexe Transmissionsfaktor des dielektrischen Resonators DR. Der dielektrische Resonator DR wirkt als Transmissionsfilter.

Bei konventionellen DRO's wird die Resonanzstelle des dielektrischen Resonators DR1, welcher auf seiner Stirnfläche SF (Fig. 3 links) liegend montiert wird, mit der niedrigsten Frequenz, welche Grundmode oder TE_{01δ}-Mode heißt, verwendet. Dabei ist der dielektrische Resonator DR eine Scheibe, ein zylindrischer Körper, aus dielektrischem verlustarmen Keramikmaterial mit einer relativen Dielektrizitätszahl ε_{R} zwischen 20 und 90. Die Ankopplung an die HF-Leitung L geschieht über die Verkopplung der magnetischen Streufelder H_{DR} und H_{MS} des dielektrischen Resonators DR und der HF-Leitung L. H_{DR} ist das magnetische Streufeld des dielektrischen Resonators DR und H_{MS} ist das magnetische Sreufeld der HF-Leitung L.

Im Gegensatz dazu wird in der Erfindung der dielektrische Resonator in aufrechter Position, d.h. er steht auf seiner Mantelfläche MF (Fig. 3 rechts) an die HF-Leitung gekoppelt. Der Resonator DR2 wird dabei in einem höheren Mode als dem Grundmode betrieben. Auch hier erfolgt die Verkopplung der Felder H_{DR} und H_{MS} von dielektrischen Resonator DR und HF-Leitung L, allerdings können in dieser erfindungsgemäßen Anordnung deutlich höhere Guten Q erzielt werden.

Figur 3 zeigt eine auf einem Substrat S angeordnete planare Hochfrequenzleitung L. Der herkömmlicher Weise auf seiner Stirnfläche SF liegende dielektrische Resonator DR1 koppelt in seinem Grundmode (TE_{01δ}-Mode) an die Leitung L an. Der Grundmode ist die niedrigste Resonanzfrequenz des dielektrischen Resonators DR. Im Gegensatz dazu wird bei der Erfindung der dielektrische Resonator DR2 auf seine Mantelflache MF gestellt und koppelt bei einem höheren Mode (TMₓₓₓ-Mode) an die HF-Leitung L an. Bei beiden Resonatoren DR1 und DR2 sind die Feldlinien H_{DR} des dielektrischen Resonators und H_{MS} der HF-Leitung schematisch eingezeichnet.

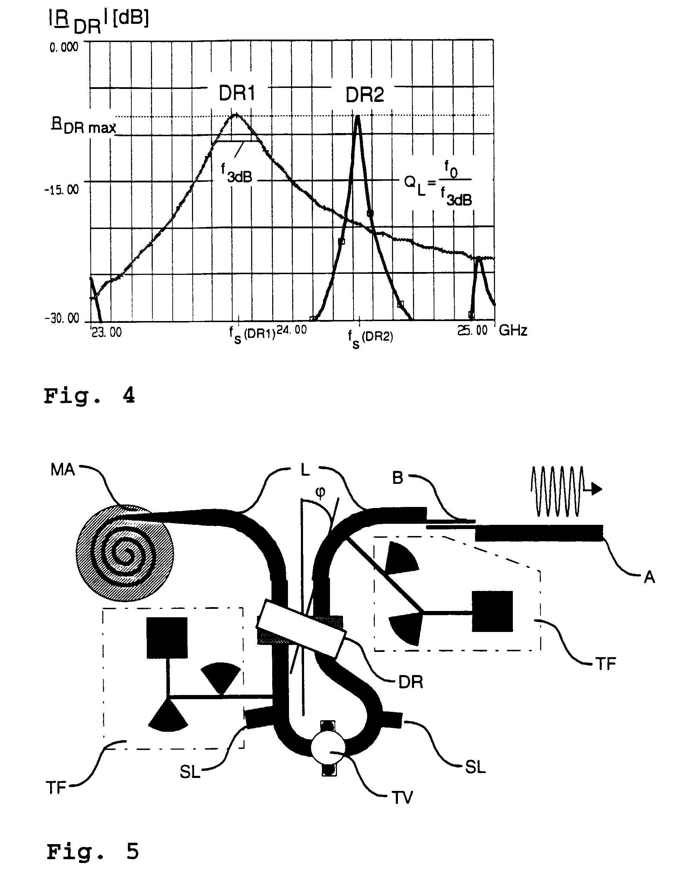

In Figur 4 sind die Messwerte der zugehörigen Filterkurven (Reflexionsfaktor |R_{DR}|) angegeben, wobei in einer Anordnung nach Figur 3 an einem Anschluß der HF-Leitung L gemessen wurde und der andere Anschluß mit einem Mikrowellenabsorber MA abgeschlossen ist. Auf dem Substrat S ist zur Messung nur ein dielektrischer Resonator DR angeordnet. Der Vergleich der Resonanzkurven der beiden verschieden angeordneten dielektrischen Resonatoren DR1 und DR2 zeigt eine deutliche Verbesserung der Filtergüte Q, wenn der dielektrische Resonator DR auf seiner Mantelflache MF stehend angekoppelt wird. Die technischen Daten der beiden für diesen Vergleich verwendeten Resonatoren DR1 und DR2 sind in folgender Tabelle angegeben:

| DR | benuzter Mode | D [mm] | h [mm] | εᵣ | Q₀.f [GHz] | Material |
|---|---|---|---|---|---|---|
| DR1 | TE_{01δ} | 2,7 | 1,1 | 29 | 100·10³ | Ba(Zr, Zn, Ta)O₃ |
| DR2 | TM_{021+δ} | 4,9 | 2,0 | 38 | 50·10³ | (Zr, Sn)TiO₄ |
| D = Durchmesser des dielektrischen Resonators DR h = Dicke des dielektrischen Resonators DR Q₀·f = Leerlaufgüte-Frequenz-Produkt des dielektrischen Resonators DR ε_{R} = relative Dielektrizitätszahl | | | | | | |

Der Zusatz +δ kennzeichnet, daß ein Teil des Feldes außerhalb des dielektrischen Resonators DR liegt.

Im Vergleich zum konventionellen TE_{01δ}-Mode wird bei der erfindungsgemäßen Lösung bei gleichem Betragsmaximum im Resonanzfall eine etwa zehnfach höhere Güte Q erreicht. Dies ist aus der Breite der in Figur 4 gezeigten Resonanzkurven zu entnehmen.

Bei gleichzeitiger Ankopplung an zwei Mikrostreifenleitungen wirkt der dielektrische Resonator DR als Transmissionsfilter. Eine Leitung wirkt als Eingang und die zweite Leitung als Ausgang, vergleiche dazu Figur 5. Diese zeigt ein Ausführungsbeispiel eines Transmissions-Typs DRO. Der dielektrische Resonator DR ist auf seiner Mantelflache stehend an die planaren Leitungen L angekoppelt. An einem Ende der planaren Leitung befindet sich ein Abschlußwiderstand in Form eines Mikrowellenabsorbers MA. Die Oszillatorschaltung ist als Mikrostreifenleitungsschaltung realisiert, das Layout ist in der Figur 5 angegeben. Die schwarzen Bereiche stellen eine Metallisierung, also eine Hochfrequenzleitung dar. Ein Transmissionsverstärker TV in Form beispielsweise eines Mikrowellentransistors wird in eine Mikrostreifenleitung L eingeschleift. Ein- und Ausgangsleitung des Verstärkers verlaufen in einem geeigneten Abstand vom Verstärker so zu einander, daß über deren magnetisches Streufeld mit einem dielektrischen Resonator DR, welcher auf seiner Mantelfläche MF steht, eine schmalbandige Überkopplung erzeugt werden kann. Der Abstand ist dann als geeignet anzusehen, wenn die folgenden zwei Bedingungen erfüllt sind: 1. Die Phase der Schleife aus dielektrischem Resonator DR, HF-Leitung L und Verstärker muß n · 360° ergeben (Oszillatorphasenbedingung). 2. Die Kopplung zwischen dem dielektrischen Resonator DR und der HF-Leitung L muß ausreichend sark sein (Oszillatorbedingung, T_{DR} < V_{T}).

Wenn der dielektrische Resonator DR nicht rechtwinkelig zu den HF-Leitungen L, sondern unter einem Winkel ϕ = 0 bis 45° schräg gestellt wird, ist eine Verbesserung der elektrischen Ankopplung zu erreichen.

Die Verstärkung des Transistors muß größer sein als der komplexe Transmissionsfaktor T_{DR} des dielektrischen Resonators DR und zusätzlich muß der gesamte Phasenumlauf n · 360° betragen, dann schwingt die Schaltung an (Oszillatorschwingbedingung: T_{DR} · V_{T} = 1).

Der Gleichspannungs-Entkopplungsfilter B in Fig. 5 dient zur gleichspannungsmäßigen Abtrennung von Oszillatorschaltung und HF-Ausgang A. Die Versorgungsspannung wird über einen Tiefpaßfilter TF, bestehend aus dünnen Leitungen (Induktivitäten) in Kombination mit Kreissektoren (Kapazitäten) zugeführt. Die Optimierung der Verstärkung des Transistors geschieht über Stichleitungen SL zur Impedanzanpassung. Die Beschaltung der beiden Verstärkerleitungen mit Mikrowellenabsorber bzw. Lastwiderstand kann je nach Anwendung unterschiedlich sein.

Durch die hohe Güte Q der verwendeten Rückkopplung ( dielektrischer Resonator DR auf der Mantelflache stehend) verringert sich entscheidend das Phasenrauschen des Oszillators und die Temperaturstabilität der Schwingfrequenz fₛ erhöht sich.

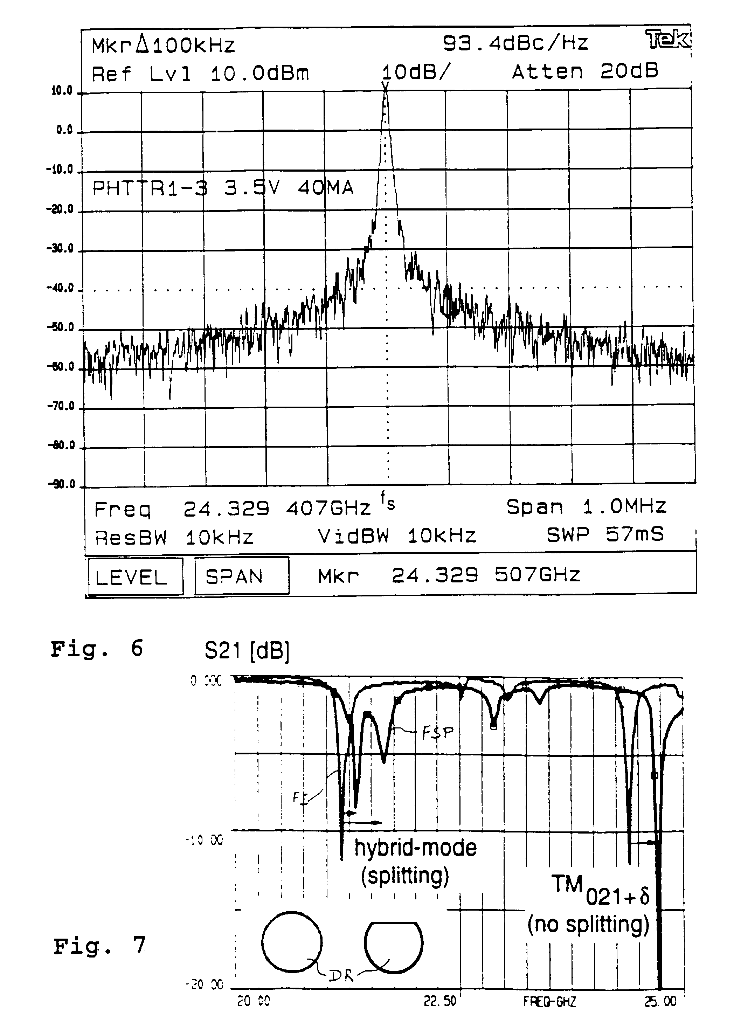

Das Ausgangssignal der in Figur 5 beschriebenen Oszillatorschaltung ist in Figur 6 gezeigt. Dabei handelt es sich um das Ausgangsspektrum, welches mit einem Spektrumanalyser aufgenommen wurde. Das Phasenrauschen liegt bei ca. -95dBc/Hz bei 100 kHz Trägerablage. Bei dem untersuchten Oszillator liegt die Schwingfrequenz fₛ bei 24,329407 GHz bei Zimmertemperatur und variiert um ca. 9ppm/°C bei Verwendung eines dielektrischen Resonators DR mit einem Temperaturkoeffizienten T_{C} = 8 ppm.

Es ist, beispielsweise zum Zecke der einfacheren Montage, möglich den kreisrunden zylindrischen dielektrischen Resonator DR an seiner Mantelfläche abzuplatten, wie in Figur 7 gezeigt ist. Dies führt dazu, daß sich die Resonanzfrequenzen in Richtung höherer Frequenzen verschieben. In der Figur 7 korrespondiert zum kreisrunden zylindrischen dielektrischen Resonator DR die gestrichelt gezeichnete erste Resonanzkurve FS. Zum an seiner Mantelfläche MF abgeplatteten dielektrischen Resonator DR gehört die durchgehend gezeichnete zweite Resonanzkurve FSP. Eine Abplattung der Mantelflache MF bewirkt weiterhin, wie aus Figur 7 ersichtlich ist, daß die Resonanzfrequenz bei nicht rotationssymmetrischen Moden in zwei Frequenzen aufgespalten wird. Bei dem TM_{021+δ} Mode tritt dieser Effekt jedoch nicht auf, weil dieser ein rotationssymmetrisches Feldlinienbild aufweist. Das hat den Vorteil, daß ein DRO, der mit einem dielektrischen Resonator DR betrieben wird unempfindlich gegenüber Störungen der geometrische Symmetrie des dielektrischen Resonators DR ist und sehr gute Eigenschaften (hohe Güte Q) beibehält. An der y-Achse ist der Transmissionsfaktor T der Anordnung nach Fig. 3 mit jedoch nur einem dielektrischen Resonator DR aufgetragen.

Bei rotationssymmetrischen Moden besteht weiterhin der Vorteil, daß eine Feinabstimmung der Resonanzfrequenz durch ein Einführen eines keramischen oder metallischen Stifts in ein im Zentrum des dielektrischen Resonators DR befindliches Loch ohne nennenswerten Güteverlust möglich ist.

Bei einem im Zentrum des dielektrischen Resonators DR vorhandenen Loch und falls nötig einem darin eingeführten Draht, wird die Resonanzfrequenz im TM_{021+δ} Mode nicht gespalten.

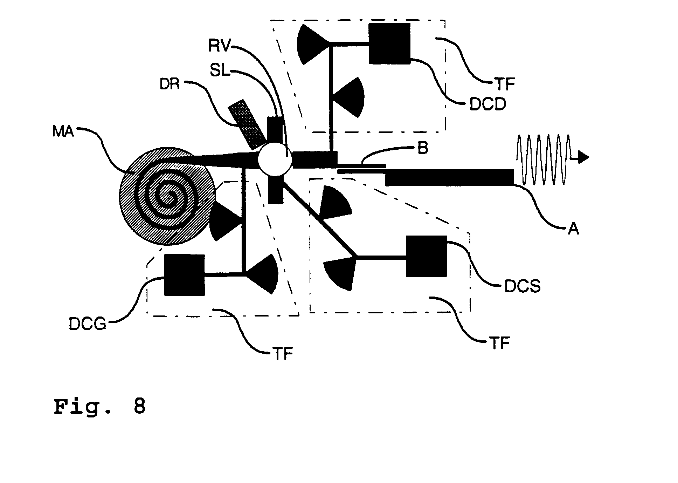

In Figur 8 ist das Beispiel eines reflection-type DROs dargestellt. Die leerlaufenden Stichleitungen SL an den Source-Anschlüssen des verwendeten Transistors, welcher den Relexionsverstärker RV bildet, machen die Schaltung schwingfähig, d.h. es wird eine Reflexionsverstarkung erzeugt. Je nach Auslegung der Schaltung oszilliert diese, wenn der dielektrischer Resonator DR auf seiner Mantelflache MF stehend in die Nähe der Leitungen L oder auch nur in die Nähe des Transistorgehäuses gebracht wird. Über einen Tiefpaßfilter TF wird (werden) die Betriebsspannung(en) zugeführt, die Fingerstruktur - das Gleichspannungsfilter B - am Ausgang A dient zur Gleichspannungs (DC)-Entkopplung und der Mikrowellenabsorber MA verhindert Reflexionen am GateAnschluß DCG des Transistors, vergleiche hierzu auch die Figur 5 des transmission-type DROs. Der Drainanschluß ist mit DCG, der Sourceanschluß mit DCS und der Gateanschluß mit DCG bezeichnet.

Prinzipiell sind viele verschiedene Konfigurationen von reflection-type DROs denkbar, siehe Bahl, Bhartia: "Microwave Solid State Circuit Design", John Wiley & Sons, 1988. Die Oszillatorschleife wird entweder durch den Reflexionsverstarker RV, den dielektrischen Resonator DR und die Leitungen L gebildet oder nur durch den Reflexionsverstarker RV und den dielektrischen Resonator DR. In Figur 8 ist am Ausgang A der Oszillatorschaltung das Ausgangssignal abgreifbar.

Der dielektrische Resonator DR ist, von der Anwendung als Rückkopplungselement in einem Hochfrequenzoszillator abgesehen, auch als HF-Filterbauelement verwendbar.

## Patentansprüche

1. Hochfrequenzoszillator in Planarbauweise mit
- einem Substrat (S) mit einer Oberseite, auf der
- ein Verstärker (RV,TV) und
- ein dielektrischer Resonator (DR) angeordnet sind,
- wobei der dielektrische Resonator (DR) in Form eines Zylinders, der von zwei Grundflächen und einer Mantelfläche begrenzt wird, oder in Form eines an seiner Mantelfläche abgeplatteten Zylinders ausgebildet ist,
- wobei der dielektrische Resonator (DR) auf seiner Mantelflache (MF) mittelbar oder unmittelbar auf oder im Substrat (S) stehend angeordnet ist,
- wobei der Verstärker (RV,TV) mit dem dielektrischen Resonator (DR) gekoppelt ist und
- wobei der Verstärker sowie die Abmessungen, die relative Dielektrizitätszahl und die Ausrichtung des dielektrischen Resonators (DR) so aneinander angepaßt sind, daß im Betrieb der Anordnung der dielektrische Resonator in einem höheren Mode als dem Grundmode betrieben wird.

2. Oszillator nach Anspruch 1,
bei dem der Verstärker sowie die Abmessungen, die relative Dielektrizitätszahl und die Ausrichtung des dielektrischen Resonators (DR) so aneinander angepaßt sind, daß im Betrieb der Anordnung der dielektrische Resonator in einem TM-Mode betrieben wird.

3. Oszillator nach Anspruch 1 oder 2,
bei dem auf der Oberseite des Substrates planare Leitungen (L) angeordnet sind und
bei dem der Verstärker (RV,TV) mittels wenigstens einer dieser planaren Leitungen (L) mit dem dielektrischen Resonator (DR) gekoppelt ist.

4. Ozillator nach Anspruch 3,
bei dem der Normalenvektor der Grundfläche des dielektrischen Resonators (DR) mit der Längsrichtung der planaren Leitung (L) einen Winkel (ϕ) im Bereich von 0° bis 45° einschließt.

5. Oszillator nach Anspruch 3 oder 4,
bei dem der Verstärker ein Transmissionsverstärker (TV) ist, der mittels zweier planarer Leitungen als Ein- bzw. Ausgangsleitung mit dem dielektrischen Resonator gekoppelt ist.

6. Oszillator nach einem der Ansprüche 1 bis 5,
bei dem der Verstärker so eingerichtet ist und bei dem der Verstärker sowie die Abmessungen, die relative Dielektrizitätszahl und die Ausrichtung des dielektrischen Resonators (DR) so aneinander angepaßt sind, daß die Frequenz des Modes, in dem der dielektrische Resonator im Betrieb der Anordnung betrieben wird, zwischen 20 GHz und 25,1 GHz liegt.

7. Oszillator nach einem der Ansprüche 1 bis 6,
bei dem der Verstärker sowie die Abmessungen, die relative Dielektrizitätszahl und die Ausrichtung des dielektrischen Resonators (DR) so aneinander angepaßt sind, daß im Betrieb der Anordnung der dielektrische Resonator (DR) bei einem Mode mit im wesentlichen rotationssymmetrischem Feldlinienbild betrieben wird.

8. Oszillator nach einem der Ansprüche 1 bis 7,
bei dem der dielektrische Resonator (DR) in seiner Grundfläche (SF) ein Loch aufweist.

## Claims

1. Radio-frequency oscillator of planar design, having
- a substrate (S) having a top side, on which
- an amplifier (RV, TV) and
- a dielectric resonator (DR) are arranged,
- the dielectric resonator (DR) being designed in the form of a cylinder bounded by two base areas and a curved surface, or being designed in the form of a cylinder which is flattened on its curved surface,
- the dielectric resonator (DR) being arranged standing on its curved surface (MF) directly or indirectly on or in the substrate (S),
- the amplifier (RV, TV) being coupled to the dielectric resonator (DR), and
- the amplifier as well as the dimensions, the relative permittivity and the orientation of the dielectric resonator (DR) being matched to one another in such a way that, during operation of the arrangement, the dielectric resonator is operated in a higher mode than the fundamental mode.

2. Oscillator according to Claim 1,
in which the amplifier as well as the dimensions, the relative permittivity and the orientation of the di-electric resonator (DR) are matched to one another in such a way that, during operation of the arrangement, the dielectric resonator is operated in a TM mode.

3. Oscillator according to Claim 1 or 2,
in which planar lines (L) are arranged on the top side of the substrate, and
in which the amplifier (RV, TV) is coupled to the dielectric resonator (DR) by means of at least one of these planar lines (L).

4. Oscillator according to Claim 3,
in which the normal vector of the base area of the dielectric resonator (DR) includes an angle (φ) in the range from 0° to 45° with the longitudinal direction of the planar line (L).

5. Oscillator according to Claim 3 or 4,
in which the amplifier is a transmission amplifier (TV) which is coupled to the dielectric resonator by means of two planar lines as input and output lines.

6. Oscillator according to one of Claims 1 to 5,
in which the amplifier is set up in such a way, and in which the amplifier as well as the dimensions, the relative permittivity and the orientation of the dielectric resonator (DR) are matched to one another in such a way, that the frequency of the mode in which the dielectric resonator is operated during operation of the arrangement lies between 20 GHz and 25.1 GHz.

7. Oscillator according to one of Claims 1 to 6,
in which the amplifier as well as the dimensions, the relative permittivity and the orientation of the dielectric resonator (DR) are matched to one another in such a way that, during operation of the arrangement, the dielectric resonator (DR) is operated in a mode having an essentially rotationally symmetrical field pattern.

8. Oscillator according to one of Claims 1 to 7,
in which the dielectric resonator (DR)- has a hole in its base area (SF).

## Revendications

1. Oscillateur haute fréquence de structure planar comportant
- un substrat (S) avec une face supérieure, sur laquelle
- un amplificateur (RV, TV) et
- un résonateur diélectrique (DR) sont disposés,
- le résonateur diélectrique (DR) étant conçu sous forme d'un cylindre limité par deux surfaces de base et une surface latérale ou sous forme d'un cylindre aplati à sa surface latérale,
- le résonateur diélectrique (DR) étant disposé sur sa surface latérale (MF) à la verticale directement ou indirectement sur ou dans le substrat (S),
- l'amplificateur (RV, TV) étant couplé au résonateur diélectrique (DR) et
- l'amplificateur, ainsi que les dimensions, le facteur de permittivité relatif et l'orientation du résonateur diélectrique (DR), étant adaptés mutuellement de telle sorte que lorsque le dispositif est en service, le résonateur diélectrique est exploité à un mode supérieur à celui du mode de base.

2. Oscillateur selon la revendication 1,
dans lequel l'amplificateur ainsi que les dimensions, le facteur de permittivité relatif et l'orientation du résonateur diélectrique (DR) sont adaptés mutuellement de telle sorte que lorsque le dispositif est en service, le résonateur diélectrique est exploité dans un mode TM.

3. Oscillateur selon la revendication 1 ou 2,
dans lequel des lignes planar L sont disposées sur la face supérieure du substrat et
dans lequel l'amplificateur (RV, TV) est couplé au résonateur diélectrique (DR) au moyen d'au moins l'une de ces lignes planar (L).

4. Oscillateur selon la revendication 3,
dans lequel le vecteur normal de la surface de base du résonateur diélectrique (DR) inclut un angle (φ) de l'ordre de 0 à 45 ° avec le sens longitudinal de la ligne planar (L).

5. Oscillateur selon la revendication 3 ou 4,
dans lequel l'amplificateur est un amplificateur à transmission (TV), couplé au résonateur diélectrique au moyen de deux lignes planar comme ligne d'entrée, resp. de sortie.

6. Oscillateur selon l'une des revendications 1 à 5,
dans lequel l'amplificateur est aménagé de telle sorte et dans lequel l'amplificateur ainsi que les dimensions, le facteur de permittivité relatif et l'orientation du résonateur diélectrique (DR) sont adaptés mutuellement de telle sorte que la fréquence du mode dans lequel le résonateur diélectrique est exploité lorsque le dispositif est en service, se situe entre 20 GHz et 25,1 GHz.

7. Oscillateur selon l'une des revendications 1 à 6,
dans lequel l'amplificateur, ainsi que les dimensions, le facteur de permittivité relatif et l'orientation du résonateur diélectrique (DR) sont adaptés mutuellement de telle sorte que lorsque le dispositif est en service, le résonateur diélectrique (DR) est exploité dans un mode avec image de lignes de champ substantiellement symétriques en rotation.

8. Oscillateur selon l'une des revendications 1 à 7,
dans lequel le résonateur diélectrique (DR) présente un trou dans sa surface de base (SF).
